# EUROPEAN PATENT SPECIFICATION

(11) **EP 1 744 452 B1**
(45) Date of publication and mention of the grant of the patent: **09.09.2009**
(21) Application number: 06009961.1
(22) Date of filing: 15.05.2006
(51) Int. Cl.: H03H 9/19, H03H 3/02

(54) **Piezoelectric substrate and method of manufacturing the same**
Piezoelektrisches Substrat und Verfahren zu dessen Herstellung
Substrat piézoélectrique et procédé pour le fabriquer

(30) Priority: 16.05.2005 JP 2005143160; 14.02.2006 JP 2006036078
(43) Date of publication of application: 17.01.2007
(73) Proprietor: Epson Toyocom Corporation, Saiwai-ku Kawasaki-shi Kanagawa-ken 212-8513 (JP)
(72) Inventor: Sato, Kenji, Kamiina-gun Nagano-ken 399-4696 (JP)
(74) Representative: HOFFMANN EITLE

(56) References cited:
- JP-A- 57 068 920
- US-A- 4 017 753
- US-A- 4 124 809
- US-A- 4 135 108
- US-B1- 6 191 524
- PATENT ABSTRACTS OF JAPAN vol. 007, no. 255 (E-210), 12 November 1983 (1983-11-12) & JP 58 141022 A (MATSUSHITA DENKI SANGYO KK), 22 August 1983 (1983-08-22)
- PATENT ABSTRACTS OF JAPAN vol. 005, no. 003 (E-040), 10 January 1981 (1981-01-10) & JP 55 134518 A (KOBAYASHI KURISUTARU KK), 20 October 1980 (1980-10-20)
- GOKA S ET AL: "Experimental study of vibrations of mesa-shaped at-cut quartz plates" PROCEEDINGS OF THE 1999 JOINT MEETING OF THE EUROPEAN FREQUENCY AND TIME FORUM, 1999 AND THE IEEE INTERNATIONAL FREQUENCY CONTROL SYMPOSIUM, 1999, vol. 1, 13 April 1999 (1999-04-13), pages 441-444, XP010377686
- POSTNIKOV I.I.: 'Effect of Temperature on Frequency Characteristics of Contoured-Quartz Thickness-Shear-Type Vibrators' ACOUSTICAL PHYSICS vol. 40, no. 4, 01 July 1994, pages 586 - 592

## Description

### BACKGROUND

### 1. Technical Field

The present invention relates to a piezoelectric substrate and a method of manufacturing the same. More particularly, the invention relates to a piezoelectric substrate that enhances the Q-value of a reduced-size piezoelectric resonator and is suitable for mass production, and a method of manufacturing the same

### 2. Related Art

Piezoelectric resonators are widely used in a variety of apparatuses ranging from communications to electronics apparatuses, owing to their compact size, low aging rate, availability of a high-precision, a highly stable frequency, and so on. Particularly, quartz crystal resonators having main vibration of the thickness shear mode are often employed in a frequency band of several MHz to several hundred MHz. Among known quartz crystal substrates employed in the quartz crystal resonators having main vibration of the thickness shear mode, are AT cut, BT cut, FC cut, IT cut, SC cut and NY cut quartz crystal substrates (See, JP-A-H10-284978 as a first example of related art). Above all, AT cut quartz crystal resonators, whose frequency-temperature characteristics form a cubic curve, are abundantly used in mobile telephones and other apparatuses of the sort.

It is known that the vibration mode of an AT cut quartz crystal resonator is thickness shear vibration in which the frequency of the resonator is inversely proportional to the thickness. Namely, the higher the frequency of the quartz crystal resonator is, the thinner the quartz crystal substrate is made, thereby rendering various characteristics of the quartz crystal resonator significantly dependent on the size of the electrodes and the amount of frequency reduced by the electrodes. On the other hand, as the frequency of a quartz crystal resonator becomes lower, the contour dimension with respect to the thickness (referred to as a side ratio) of the quartz crystal resonator becomes more important an element. Thus, in this case, the main point in designing is how to appropriately set the side ratio to avoid higher-order contour vibrations.

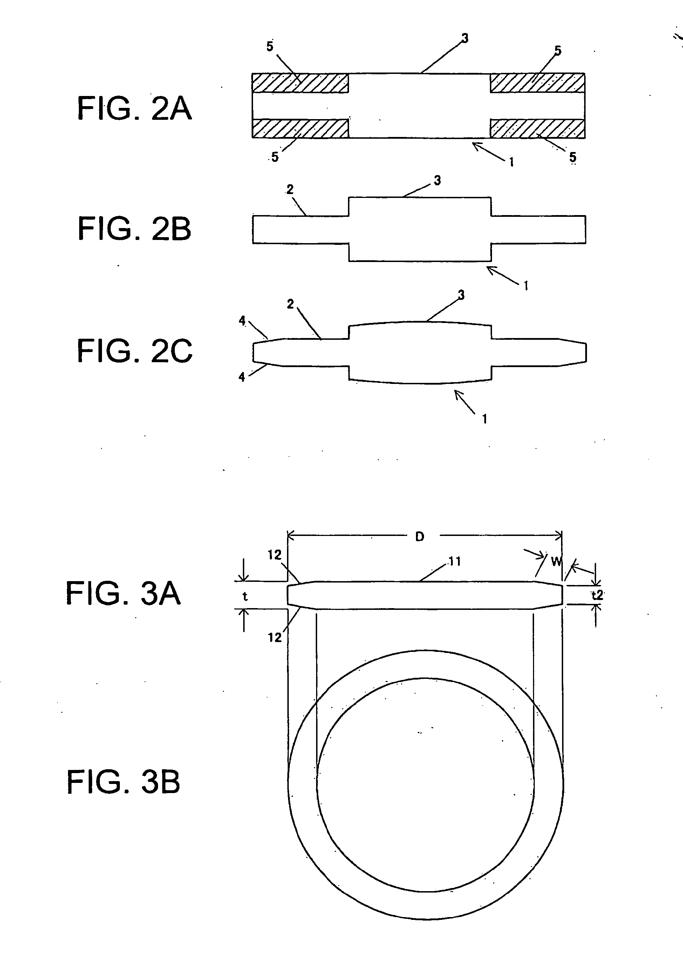

Fig. 3A and 3B are diagrams showing the structure of a disk-like quartz crystal substrate, Fig. 3A being a cross sectional view and Fig. 3B being a top view. When frequency of the quartz crystal resonator is low, the ratio of diameter D with respect to thickness t of a quartz crystal substrate 11, i.e. value of the side ratio (D/t), is small. In such a case, the vibration energy of the thickness shear mode, the main vibration, is not so distributed as to be adequately concentrated on the central portion, so that the energy reaches the end part. The vibration energy reaching the end part excites contour vibrations such as a higher-order flexural vibration and a higher-order face shear vibration, for example. As a result, the Q-value of the main vibration deteriorates, thereby making a quartz crystal resonator having plenty of spurious modes. Thus, the vibration energy of the main vibration can be made to concentrate on the central portion if both end parts of the quartz crystal substrate are ground to be added with bevels 12, as shown in Fig. 3A. Designing of a quartz crystal resonator depends on how to design the side ratio D/t, width W of the bevels 12 and end thickness d of a quartz crystal substrate 11 in order to realize a resonator having a higher Q-value and less spurious mode.

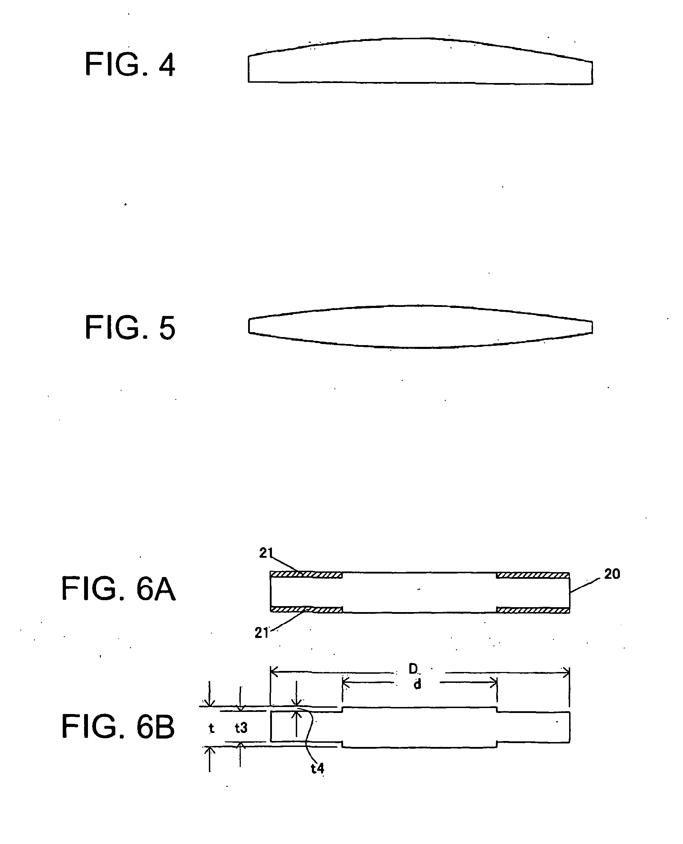

Fig. 4 is a diagram showing a cross sectional view of a plano-convex quartz crystal substrate, one of the main surfaces of the substrate having been ground such that it forms a lens-like shape (spherical shape) in order to have the vibration energy of the main vibration concentrate on the central portion of the substrate. The substrate is mainly used in quartz crystal resonators intended for a higher stabilization. The other main surface is made flat, so that the cutting angle of the substrate can be maintained. Therefore, a quartz crystal resonator made with a plano-convex quartz crystal substrate has both a larger Q-value and good frequency-temperature characteristics.

Fig. 5 is a diagram showing a cross section of a double-convex quartz crystal substrate. The substrate makes a quartz crystal resonator with a higher Q-value, but some variations may occur in the frequency-temperature characteristics, depending on the accuracy of the spherical processing.

These days, a further size-reduction and lower prices are required for quartz crystal resonators. One of the ways to meet this requirement is a mesa type quartz crystal substrate made by processing the main surfaces of a quartz crystal substrate into the shape of a mesa. Figs. 6A and 6B are diagrams showing cross sections of a mesa type quartz crystal substrate. The shaded areas in Fig. 6A are etched by the photolithography and etching techniques that are performed on a flat plate quartz crystal substrate 20 to form the mesa type quartz crystal substrate shown in Fig. 6B. By allowing use of the photolithography and etching techniques, this type of quartz crystal substrate enables the manufacture of reduced-size quartz crystal substrates by larger amounts and at lower costs. Features of this reduced-size quartz crystal substrate include its ability to concentrate the main vibration energy on the mesa part so as to make a quartz crystal resonator having a higher Q-value.

Sadao Taki, "Synthetic Quartz and its Electrical Application," The Nikkan Kogyo Shinbun, Ltd., May 1974 is a second example of

### related art.

V E. Bottom, "Introduction to Quartz Crystal Unit Design," Van Nostrand Reinhold, January 1982 is a third example of related art.

However, even if proper settings are made for the contour dimension D of the mesa type quartz crystal substrate, the dimension d and thickness t of the vibrating part, the end thickness t3, and the thickness t4 of the etched parts, which are illustrated in Fig. 6B, a problem still exists in that the Q-value of a quartz crystal resonator varies, and spurious modes are generated, because of variability in the size of a quartz crystal substrate formed.

US 6, 191, 524 discloses a substrate according to the preamble of claim 1.

### SUMMARY

According to the invention, a piezoelectric substrate is made as recited in claim 1.

The piezoelectric substrate may have a circular form.

In this case, the piezoelectric substrate may have a rectangular form.

According to claim 4 of the invention, a method of manufacturing a piezoelectric substrate is provided.

An advantage of the piezoelectric substrate according to the invention is that it is capable of trapping the vibration energy of the main vibration in the central portion to avoid linkage with higher-order contour vibrations. This is owing to a spherical processing performed on the mesa structure in the center and the circumferential edge parts on each side of the substrate so that they form together part of a spherical shape. Thus, the substrate, when used in a resonator, is capable of realizing a piezoelectric resonator having a larger Q-value and less spurious modes.

### BRIEF DESCRIPTION OF THE DRAWINGS

The invention will be described with reference to the accompanying drawings, wherein like numbers reference like elements.

Figs. 1A, 1B, 1C and 1D are diagrams showing the structure of a quartz crystal substrate (mesa-bevel type quartz crystal substrate) according to a first aspect of the invention, Fig. 1A being a top view and Fig. 1B being a cross sectional view.

Figs. 2A, 2B and 2C are cross sections showing the process of manufacturing a quartz crystal substrate (mesa-bevel type quartz crystal substrate) according a second aspect of the invention.

Figs. 3A and 3B are diagrams showing a related art bevel-processed type quartz crystal substrate, Fig. 3A being a cross sectional view and Fig. 3B being a top view.

Fig. 4 is a cross sectional view showing the structure of a plano-convex quartz crystal substrate.

Fig. 5 is a cross sectional view showing the structure of a double-convex quartz crystal substrate.

Figs. 6A and 6B are cross sectional views showing the structure of a mesa type quartz crystal substrate.

### DESCRIPTION OF THE EMBODIMENTS

Embodiments of the invention will now be described with reference to the accompanying drawings.

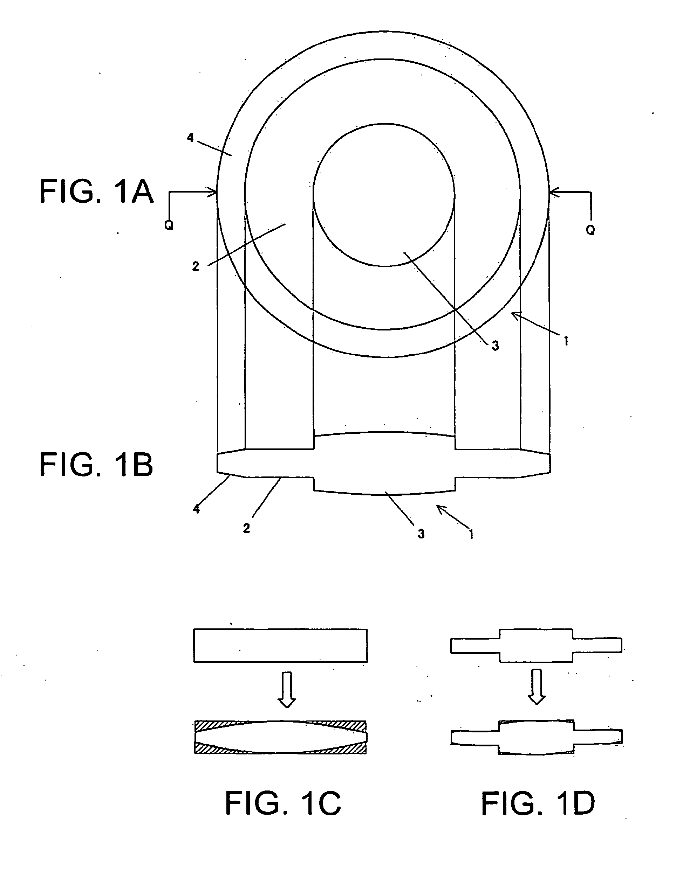

Figs. 1A and 1B are diagrams showing a quartz crystal substrate according to a first embodiment of the invention, Fig. 1A being a top view and Fig. 1B being a cross sectional view. The substrate is made in such a manner that protruding portions (mesa portions) 3 of a predetermined size are integrally formed in the center of both sides of an AT cut quartz crystal substrate 1 having the shape of a flat plate, vertically opposed to each other, while the top surface of each protruding portion 3 and a circumferential edge part (bevel part) 4 of the flat plate portion, which continues from the protruding portion 3, together form part of an identical spherical shape.

The method of manufacturing a quartz crystal substrate according to a second embodiment of the invention (hereinafter referred to as a mesa-bevel type quartz crystal substrate) will now be described using the cross sectional views shown in Figs. 2A, 2B and 2C. First, as shown in Fig. 2A, an etching is performed by a predetermined amount of thickness using the photolithographic and etching techniques on peripheral portions 5 of the AT cut quartz crystal plate 1 of a given thickness, leaving a central portion 3 thereof intact. Thus, as shown in Fig. 2B, a quartz crystal substrate having vertically opposed protruding portions 3 integrally formed in the center of both sides of a flat plate portion 2 (a mesa type quartz crystal substrate) is formed. Then, the mesa type quartz crystal substrate is placed into a cylindrical container together with some abrasive powder. As the container is rotated at a predetermined rotation rate, circumferential edge parts 4 of the flat plate, touching the internal sidewall of the container, is ground to form the shape of a wedge. As grinding of the circumferential edge parts 4 progresses, top surfaces of the protruding portions 3 that are formed in the center of both sides of the quartz crystal substrate 1 come into contact with the sidewall of the cylindrical container, to be ground by friction. Namely, the internal shape of the cylindrical container is transferred to the surfaces of the protruding portions 3 and the circumferential edge parts 4 of the flat plate, thereby rendering the surfaces to form the shape of a spherical surface.

A quartz crystal resonator made with the above mesa-bevel type quartz crystal substrate has a higher Q-value and less spurious modes as compared with a quartz crystal resonator made with either a mesa type quartz crystal substrate or a bevel type quartz crystal substrate. The reason may be that, in the mesa-bevel type quartz crystal substrate, the top surfaces of the mesa portion and the circumferential edge parts of the substrate are respectively processed or bevel-processed into the shape of a spherical surface, so that the substrate is capable of concentrating the vibration energy of the main vibration more into the central portion, thereby reducing the vibration energy that excites higher-order contour vibrations at the end part.

The amount to be ground of a quartz crystal substrate depends virtually on its own weight of a substrate and the rotation rate of a cylindrical container. Therefore, as a quartz crystal substrate becomes smaller and with less empty weight due to size-reduction of a quartz crystal resonator, the time consumed for a bevel-processing increases. At the same time, if a bevel-processing takes a longer time, the quartz crystal substrate freely moving inside the cylindrical container is often ground more than necessary at its corners or ground to have a shape that is different from the curvature of the container, and so on. Owing to the protruding portions (mesa portions) that are processed into the shape of a spherical surface, the mesa-bevel quartz crystal substrate according to the invention is capable of adequately trapping the vibration energy of the main vibration to the mesa portions, thereby reducing the amount of the circumferential edge parts to be bevel-processed. For example, in the case of the substrate shown in Fig. 5, the amount of the circumferential edge parts to be ground by bevel-processing, as shown by the shaded parts in Fig. 1C, is large as compared with a quartz crystal substrate that is processed into a mesa substrate in advance, in which the amount to be ground is considerably small, as shown by the shaded parts in Fig. 1D. A reduced bevel-processing time allows a quartz crystal substrate to obtain a shape that is closer to a designed shape and allows also a quartz crystal resonator to have better properties. Moreover, a reduced bevel-processing time also realizes less variation in the bevels of a substrate as well as in the characteristics of a quartz crystal resonator.

The process of forming a mesa-bevel quartz crystal substrate was described in the above, which includes forming a mesa quartz crystal substrate using a circular flat plate and then performing bevel-processing in a cylindrical container. It is needless to explain that a mesa-bevel type quartz crystal substrate can also be made by using a rectangular flat plate. In addition, a process that is suitable for mass production of a reduced-size mesa-bevel quartz crystal substrate includes forming a number of mesa structures in a matrix on an AT cut substrate of a given thickness, cutting them up into individual pieces and then processing the mesa portions and the circumferential edge parts of the flat plate into the shape of a spherical surface.

The present invention is not limited to the embodiments described above, but various changes and modifications may be added for implementation of the above embodiments, within the technical scope of the invention. For example, the invention may be applied not only to AT cut quartz crystal substrates, but also to those quartz crystal substrates whose main vibration is in a thickness shear mode, including, for example, a BT cut, FC cut, IT cut, SC cut, NY cut and other quartz crystal substrates. Furthermore, besides quartz crystal substrates, the invention is also applicable to piezoelectric substrates including lithium niobate, lithium tantalate, lithium tetraborate, langasite, piezoelectric ceramic and other sorts of piezoelectric substrates.

## Claims

1. A piezoelectric substrate (1) comprising:
a first protruding mesa portion (3) , the first protruding mesa portion being formed integrally in the center of one side of the substrate;
a first circumferential bevel (4) in a flat plate portion (2) of the substrate which continues from the first protruding mesa portion, the first circumferential bevel being formed on the one side of the substrate;
a second protruding mesa portion (3), the second protruding mesa portion being formed integrally in the center of the other side of the substrate; and
a second circumferential bevel (4) in the flat plate portion (2) of the substrate which continues from the second protruding mesa portion, the second circumferential bevel being formed on the other side of the substrate,
**characterized in that** the first protruding mesa portion has a first curved surface, the second protruding mesa portion has a second curved surface, the first curved surface and the surface of the first circumferential bevel together form part of an identical spherical surface, and the second curved surface and the surface of the second circumferential bevel together form part of an identical spherical surface.

2. The piezoelectric substrate according to claim 1, the substrate having a circular shape.

3. The piezoelectric substrate according to claim 1, the substrate having a rectangular shape.

4. A method of manufacturing a piezoelectric substrate (1), comprising the steps of :
providing a piezoelectric substrate (1) having the shape of a flat plate with a given thickness;
etching a peripheral portion of the substrate by a predetermined thickness while maintaining the given thickness in the central portion of the substrate so as to form a mesa type substrate having a first protruding mesa portion which is integrally formed in the center of one side of the substrate and a second protruding mesa portion which is integrally formed in the center of the other side of the substrate and a flat plate portion (2) continuing from the protruding mesa portions;
putting the mesa type substrate into a cylindrical container together with an abrasive compound; and
rotating the container so as to form a first curved surface on the first protruding mesa portion (3), a second curved surface on the second protruding mesa portion (3), a first circumferential bevel (4) on one side of the flat plate portion of the substrate, and a second circumferential bevel (4) on the other side of the flat plate portion of the substrate by grinding; the curved surfaces being formed so that the first curved surface and the surface of the first circumferential bevel form part of an identical spherical surface, and the second curved surface and the surface of the second circumferential bevel form part of an identical spherical surface.

## Patentansprüche

1. Piezoelektrisches Substrat (1) umfassend:
einen ersten hervorstehenden Mesaabschnitt (3), wobei der erste hervorstehende Mesaabschnitt integral in dem Zentrum einer Seite des Substrats ausgebildet ist;
eine erste Umfangsschrägkante (4) in einem flachen Plattenabschnitt (2) des Substrats, der sich an den ersten hervorstehenden Mesaabschnitt anschließt, wobei die erste Umfangsschrägkante an der einen Seite des Substrats ausgebildet ist;
einen zweiten hervorstehenden Mesaabschnitt (3), wobei der zweite hervorstehende Mesaabschnitt integral in dem Zentrum der anderen Seite des Substrats ausgebildet ist; und
eine zweite Umfangsschrägkante (4) in dem flachen Plattenabschnitt (2) des Substrats, der sich an den zweiten hervorstehenden Mesaabschnitt anschließt, wobei die zweite Umfangsschrägkante an der anderen Seite des Substrats ausgebildet ist,
**dadurch gekennzeichnet, dass** der erste hervorstehende Mesaabschnitt eine erste gekrümmte Oberfläche aufweist, der zweite hervorstehende Mesaabschnitt eine zweite gekrümmte Oberfläche aufweist, die erste gekrümmte Oberfläche und die Oberfläche der ersten Umfangsschrägkante zusammen einen Teil einer identischen Kugelfläche bilden und die zweite gekrümmte Oberfläche und die Oberfläche der zweiten Umfangsschrägkante zusammen einen Teil einer identischen Kugelfläche bilden.

2. Piezoelektrisches Substrat nach Anspruch 1, wobei das Substrat eine Kreisform aufweist.

3. Piezoelektrisches Substrat nach Anspruch 1, wobei das Substrat eine rechteckige Form aufweist.

4. Verfahren zum Herstellen eines piezoelektrischen Substrats (1) umfassend die folgenden Schritte:
Bereitstellen eines piezoelektrischen Substrats (1), das die Form einer flachen Platte mit einer gegebenen Dicke aufweist;
Ätzen eines Umfangsabschnitts des Substrats um eine vorgegebene Dicke, während die gegebene Dicke in dem Zentrumsabschnitt des Substrats beibehalten wird, um so ein Substrat in Mesaausführung auszubilden, das einen ersten hervorstehenden Mesaabschnitt, der integral in dem Zentrum einer Seite des Substrats ausgebildet ist, und einen zweiten hervorstehenden Mesaabschnitt, der integral in dem Zentrum der anderen Seite des Substrats ausgebildet ist, und einen flachen Plattenabschnitt (2), der sich an die hervorstehenden Mesaabschnitte anschließt, aufweist;
Setzen des Substrats in Mesaausführung in einen zylindrischen Behälter zusammen mit einem Schleifgemisch; und
Drehen des Behälters, um so eine erste gekrümmte Oberfläche an dem ersten hervorstehenden Mesaabschnitt (3), eine zweite gekrümmte Oberfläche an dem zweiten hervorstehenden Mesaabschnitt (3), eine erste Umfangsschrägkante (4) an einer Seite des flachen Plattenabschnitts des Substrats und eine zweite Umfangsschrägkante (4) an der anderen Seite des flachen Plattenabschnitts des Substrats durch Schleifen auszubilden; wobei die gekrümmten Oberflächen so ausgebildet sind, dass die erste gekrümmte Oberfläche und die Oberfläche der ersten Umfangsschrägkante einen Teil einer identischen Kugelfläche bilden und die zweite gekrümmte Oberfläche und die Oberfläche der zweiten Umfangsschrägkante einen Teil einer identischen Kugelfläche bilden.

## Revendications

1. Substrat piézoélectrique (1) comprenant:
une première portion mesa protubérante (3), la première portion mesa protubérante étant formée intégralement au centre d'un côté du substrat;
un premier chanfrein circonférentiel (4) dans une portion de plaque plate (2) du substrat qui s'étend de la première portion mesa protubérante, le premier chanfrein circonférentiel étant formé sur l'un côté du substrat;
une deuxième portion mesa protubérante (3), la deuxième portion mesa protubérante étant formée intégralement au centre de l'autre côté du substrat; et
un deuxième chanfrein circonférentiel (4) dans la portion de plaque plate (2) du substrat qui s'étend de la deuxième portion mesa protubérante, le deuxième chanfrein circonférentiel étant formé sur l'autre côté du substrat,
**caractérisé en ce que** la première portion mesa protubérante a une première surface incurvée, la deuxième portion mesa protubérante a une deuxième surface incurvée, la première surface incurvée et la surface du premier chanfrein circonférentiel font partie d'une surface sphérique identique, et la deuxième surface incurvée et la surface du deuxième chanfrein circonférentiel font partie d'une surface sphérique identique.

2. Substrat piézoélectrique selon la revendication 1, le substrat ayant une forme circulaire.

3. Substrat piézoélectrique selon la revendication 1, le substrat ayant une forme rectangulaire.

4. Procédé de fabrication d'un substrat piézoélectrique (1), comprenant les étapes qui consistent à:
fournir un substrat piézoélectrique (1) ayant la forme d'une plaque plate avec une épaisseur donnée;
attaquer chimiquement une portion périphérique du substrat par une épaisseur prédéterminée tout en maintenant l'épaisseur donnée dans la portion centrale du substrat de manière à former un substrat du type mesa ayant une première portion mesa protubérante qui est formée intégralement au centre d'un côté du substrat et une deuxième portion mesa protubérante qui est formée intégralement au centre de l'autre côté du substrat et une portion de plaque plate (2) s'étendant depuis les portions mesa protubérantes;
mettre le substrat du type mesa dans un conteneur cylindrique avec un composé abrasif; et
faire tourner le conteneur de manière à former une première surface incurvée sur la première portion mesa protubérante (3), une deuxième surface incurvée sur la deuxième portion mesa protubérante (3), un premier chanfrein circonférentiel (4) sur un côté de la portion de plaque plate du substrat, et un deuxième chanfrein circonférentiel (4) sur l'autre côté de la portion de plaque plate du substrat par un broyage; les surfaces incurvées étant formées de sorte que la première surface incurvée et la surface du premier chanfrein circonférentiel font partie d'une surface sphérique identique, et la deuxième surface incurvée et la surface du deuxième chanfrein circonférentiel font partie d'une surface sphérique identique.
